# EUROPEAN PATENT SPECIFICATION

(11) **EP 4 647 795 B1**
(45) Date of publication and mention of the grant of the patent: **29.07.2026**
(21) Application number: 24174632.0
(22) Date of filing: 07.05.2024
(51) Int. Cl.: G01R 33/36

(54) **NMR PROBE HEAD WITH COMPACT MECHANISM FOR REMOTELY TUNING, MATCHING AND CONTROLLING AN NMR PROBE**
NMR-PROBENKOPF MIT KOMPAKTEM MECHANISMUS ZUR FERNABSTIMMUNG, -ANPASSUNG UND -STEUERUNG EINER NMR-PROBE
TÊTE DE SONDE RMN AVEC MÉCANISME COMPACT POUR L'ACCORD, L'ADAPTATION ET LA COMMANDE À DISTANCE D'UNE SONDE RMN

(43) Date of publication of application: 12.11.2025
(73) Proprietor: Bruker Biospin GmbH & Co. KG, 76275 Ettlingen (DE)
(72) Inventor: Bandara, Priyanga, 76228 Karlsruhe (DE)
(74) Representative: Kohler Schmid Möbus Patentanwälte

(56) References cited:
- WO-A1-2019/100173
- US-A- 5 274 330
- US-B1- 6 204 665
- US-B1- 6 323 647
- US-B2- 7 800 369

## Description

The invention relates to an NMR probe head for use in an NMR spectrometer, the probe head containing a mechanical apparatus designed and adapted for remotely tuning, matching and controlling an NMR probe head during operation of the NMR spectrometer, the mechanical apparatus comprising a plurality of adjustment rods to mechanically adjust mechanical or electric parts in the NMR probe head requiring manipulation, the adjustment rods essentially arranged in a Z-direction and being mechanically coupled to an actuator via an engagement system, and containing a control system to control the movement of the actuator.

Such NMR probe head is known from US 6,204,665 B1 (= **Reference [1]).**

### Technical background of the invention

In general, the present invention relates to the technical field of magnetic resonance. Nuclear magnetic resonance (="NMR") spectroscopy is a powerful tool in instrumental chemical analysis and a commercially widespread method for analyzing and characterizing the chemical composition of substances. In NMR experiments, a sample is exposed to a strong static magnetic field, which interacts with spins of nuclei contained in the sample. Radio frequency (="RF") pulses are sent into the sample for manipulating the spins, and the sample's reaction, i.e. RF signals (also called "NMR signals") are measured. The sample's reaction depends on the environment of the nuclei in the sample, in particular bonding electrons. Accordingly, information about the chemical structure of the sample can be obtained by analysing the NMR signals measured.

In solid state NMR spectroscopy, to reduce line expansions due to anisotropic interactions, having an NMR sample rotate at high frequency (typically several kilohertz) during the spectroscopic measurement tilted at the so-called "magnetic angle" of arctan√2 ≈ 54,74° in relation to the static magnetic field is furthermore known ("MAS" = Magic Angle Spinning). For this purpose, the sample is packed into an MAS rotor. MAS rotors are generally cylindrical tubes open on one side, which are closed with a cap, wherein the cap is provided with wing elements, in particular small bladed wheels. The MAS rotor is arranged in an MAS stator, and the MAS rotor is driven via the wing elements for rotation using gas pressure.

### Special prior art

US 5,274,330 A (= **Reference [2])** discloses a drive system for controlling adjustment of a plurality of actuators in an NMR spectrometer. The actuating drive comprises a drive train including one drive motor coupled to a drive shaft and a plurality of drive train output. The apparatus further comprises wheel means for coupling to a plurality of wheels driving the plurality of actuators.

The drive motor is in a fixed position and the rods are coupled to the drive motor via a gearbox arrangement.

US 6,323,647 B1 (= **Reference [3])** describes a drive system for tuning an NMR probe using an actuator (in form of a motor) coupling to several drive rods by a gearing. A second motor changes the position of the actuator in one dimension to connect the different drive rods. In this system, one actuator can control more than one element in the probe, but the number of elements that can be controlled by one actuator is quite limited. Also, the gearing mechanism does not allow for a compact design the actuator cannot be moved in 3-dimensions to give access any location at the bottom of the probe.

WO 2019/100173 A1 (= **Reference [4])** discloses an NMR probe in which a plurality of actuators are directly connected to the adjustment rods. The actuators are piezoelectric tuning elements in NMR probe heads.

US 7,800,369 B2 (= **Reference [5])** describes an NMR probe with a plurality of selectable linear adjustment rods, which are driven by a single actuator in form of a motor. The rods are connected to the motor by a respective driven gear, azimuthally locked to the rods. When the driven gear engages a driving gear, a single driving motor is energized and controlled to affect the desired adjustment. No movement of the motor itself is possible.

In the apparatus according to **Reference [1]** (already cited) the positioning of the control units is consisting of one or more drive units, one or more gear units, as well as one or more drive shafts within the probe head. The location of the control unit(s) stays the same. The way they are build and operate changes, however. The apparatus uses one motor as an actuator for each item that needs to be adjusted, each of the items being fixed to its rod.

Most of the currently known prior art solutions are based on multiple fixed mechanical actuators and necessitate one dedicated actuator for each component that require adjustment. The actuators are typically arranged in the bottom box of the probe head, with each drive unit being directly connected to an adjustment rod, which also drives it. This arrangement is quite bulky and disadvantageous in cases where several adjustment rods are required for special probe heads.

Other solutions provide a single drive motor which can be coupled to several adjustment rods by gearings, but all proposed solutions are space consuming and technically complex. This is specially challenging considering the large number components that need to be controlled and the very limited space that is available to place all the actuators in **NMR** probes.

For example, in an **NMR** probe head designed for 4 different nucleus frequencies, at least 9 adjustment rods are needed for tuning and matching the frequencies, which requires a correspondingly large amount of space, especially if voluminous gear units are used to translate the rotary motion into translational motion. The drive units, which are usually located in the bottom box of the probe head, also require more space than is usually available.

At the moment, because of space constraints the number of available actuators available in Standard Bore ("SB") probes have been limited to less than 10. Even with this limited number of actuators, because there is not enough space directly under components that require adjustment, complicated mechanical coupling mechanisms or links are needed to link the actuators to the components that require manipulation.

Also, because each component that requires manipulation needs a dedicated actuator, as the number of components that need controlling goes up, the complexity of the control electronics becomes even more complicated.

In addition, current solutions are limited to translation motion along the Z-direction (along the length of the probe) and rotational motion.

### Objects of the invention

It is an object of the present invention is to provide a space-saving mechanism that drives all adjustment rods inside an NMR probe head with as few drive units as possible. The system should have a low level of complexity and fulfill all movement requirements (namely rotation and translation) and thus be suitable as a platform solution for all types of probe heads.

In particular, one of the main points of the invention should be that, unlike previous solutions, the complexity of the mechanics should not increase with the number of components that need to be adjusted. Any number of components should be controllable with as few actuators as possible.

A further main task of the invention is to facilitate automatic tuning, matching, activation of mechanical switches in NMR probes in general, and additionally in MAS NMR probes also the adjustment of orientation of the MAS stator.

### Brief description of the invention

This object is achieved, in accordance with the present invention and in a surprisingly simple and effective way, by a generic NMR probe head as initially defined, which is characterized in that the mechanical apparatus comprises an actuator platform to which the actuator is attached, the platform being movably connected to a carrier stage; that the carrier stage is equipped with three actuating elements arranged thereon and enabling the carrier stage to move the actuator platform into any required spatial position relative to the adjustment rods; and that the engagement system comprises receiving elements arranged on the lower ends of each of the adjustment rods and an inserting element arranged on the top end of the actuator, wherein the inserting element is designed and adapted for fitting in anyone of the receiving elements to mechanically couple the corresponding adjustment rod with the actuator to provide a transmission of rotational and/or translational movement from the actuator to the adjustment rod.

The main idea of the present invention is to control any number of components that require manipulation by employing only just four actuators in total, namely one main actuator to drive the rods and three actuating elements to precisely position the main actuator under the components that require manipulation. Because this main actuator can be positioned directly under anyone of the components that need to be controlled, complicated coupling links or mechanisms are not required anymore.

The main actuator is provided with an engagement system allowing to positively engage the actuating rods so that a rotary movement of the main actuator can be transmitted to the actuating rods.

The three actuating elements can be arranged on an XYZ stage which move the positioning platform, on which the main actuator is fixed, in all directions. As an alternative of an XYZ-stage, a cylindrical sample stage can be used on which the positioning platform is pivoted and moved radially instead of the XY-movement.

The main actuator and the actuating elements are for example DC motors, piezoelectric units or even pneumatic elements and can be controlled directly or indirectly via the spectrometer console. In preferred embodiments, the actuating elements will be indirectly controlled by the spectrometer console. In this case the spectrometer console will only provide high-level instructions to the probe, such as requesting the probe to tune a specific channel to a specific frequency or in case of a Magic Angle Spinning (MAS) probe, to change the orientation of the stator.

With the present invention, the number of pieces and the geometry is minimalized, since only one main actuator and three actuating elements are required in contrast to the state-of-the-art solutions which are all much more space demanding.

The system can easily be adapted to existing or commercially available NMR spectrometers without any modification in the magnet bore.

### Preferred embodiments and further developments of the invention

In a first class of embodiments of the invention, the carrier stage is designed and adapted for moving the actuator platform in Cartesian XYZ-coordinates, comprising a first actuating element for linear motion in an X-direction, a second actuating element for linear motion in a Y-direction perpendicular to the X-direction, and a third actuating element for linear motion in the Z-direction perpendicular to the X-direction and the Y-direction and parallel to the direction of the axes of the adjustment rods.

XYZ stages require only a few components to be assembled in a straightforward manner and allow for moving the actuator platform efficiently in three spatial directions.

An alternative second class of embodiments is characterized in that the carrier stage is designed and adapted for moving the actuator platform in cylindrical pφZ-coordinates, comprising a first actuating element for linear motion in a radial p-direction, a second actuating element for rotary motion in a φ-direction, and a third actuating element for linear motion in the Z-direction parallel to the direction of the axes of the adjustment rods.

Also cylindrical can be used on which the actuator platform is pivoted and moved radially instead of the XY-movement.

In both classes of embodiments introduced above, it can be of advantage, if the mechanical apparatus is designed and adapted for enabling a combined translational and rotational movement of the main actuator, whereby the actuator is performing a rotational motion and the third actuating element is performing a linear motion in Z-direction which is transmitted to the main actuator via the actuator platform.

For example, the actuating element in the Z-direction can first make a coarse adjustment in the translational Z-direction, as is done for example when flipping an MAS stator in the direction of the magic angle, and then the precision adjustment can be made in a second step by the main actuator by means of a rotary movement, whereby the MAS stator is precisely adjusted to the magic angle.

In especially preferred embodiments of the invention, the engagement system is provided with a latching/unlatching mechanism enabling the inserting element of the main actuator to be locked in the receiving element of an adjustment rod in a releasable manner.

This serves to connect the main actuator to the actuating rods in such a way that translational movements in both Z-directions are also possible, i.e. that it serves both as a push rod and as a pull rod (movement in -Z as well as in +Z direction).

Advantageous variants of these embodiments are characterized in that the latching/unlatching mechanism can be locked and released mechanically and/or electro-magnetically.

A further class of preferred embodiments is characterized in that the control system comprises a hardware portion to generate motion and a software interface to control the motion of the three actuating elements of the carrier stage for moving the actuator platform into a spatial position appropriate for coupling the main actuator to a selected adjustment rod, for coupling the main actuator to this selected adjustment rod, and for operating the main actuator according to the requirements of moving this selected adjustment rod in order to mechanically adjust the mechanical or electric part of an **NMR** probe connected to this selected adjustment rod.

High-level instructions will be received by the control system. Its units will be usually located in the bottom housing of the **NMR** probe head. These control units comprise electronic hardware and software. They will contain the necessary information specific to the that **NMR** probe head, such as,
1. Which components need to be adjusted to achieve the result requested.
2. The location ((x, y, z) coordinates or (p, φ, z) in case of cylindrical coordinates) of the rods or any other type of links that are connected to all the components that can be adjusted by the main actuator.
3. The type of motion e.g. linear or rotational required to adjust each of the components in the probe.

With the use of this control system, a user can simply set the type of measurement to be carried out via the operating software or an interface in the software and the control system performs the settings in the probe head.

Particularly preferred are variants of these embodiments, in which the software interface of the control system is designed and adapted for automatically initiating and controlling the motion of the three actuating elements of the carrier stage and of the actuator mounted to the actuator platform upon input of high-level instructions to the **NMR** probe in a spectrometer console by a user of the **NMR** spectrometer.

Using the above information, the control system located in the **NMR** probehead will move the main actuator to the correct position to adjust the necessary components in the probe to achieve the task requested by the user via the spectrometer console.

These variants can be further improved in that the software interface of the control system is designed and adapted to facilitate automatic tuning, matching, activation of mechanical switches in NMR probes, and preferably additionally in MAS-NMR probes, the adjustment of orientation of an MAS stator.

This also means that only one single automatic control system will be needed for all probes.

Preferentially, the adjustment rods are designed and adapted to mechanically adjust trimmer capacitors, variable resistors, switches, or inductors and/or MAS angle adjustment elements.

The actuating rods in the NMR probe head are mainly designed as drive systems for the trimmers, i.e. the adjustable capacities, whereby the actuating rod can translate the rotational movement of the main actuator into a translational movement by means of a gear mechanism. These gear mechanisms require additional space in the probe head, which is particularly problematic in probes for a standard bore with a diameter of 4 cm. Therefore, the positioning device can also be moved in the Z-direction by an actuator.

Further embodiments being very utile in practice are characterized in that the main actuator mounted to the actuator platform and/or one or more of the three actuating elements of the carrier stage comprise a DC motor, a piezoelectric element or a pneumatic operator.

The actuators, including the main actuator and the actuating elements, for e.g. DC motors, piezoelectric actuators or even pneumatic actuators can be controlled directly or indirectly via the spectrometer console. In other embodiments, the actuators will be indirectly controlled by the spectrometer console as introduced below.

The present invention also comprises a Nuclear Magnetic Resonance spectrometer comprising an NMR probe head as described above, characterized in that the NMR spectrometer comprises a spectrometer console controllable by a user of the NMR spectrometer by providing the input of high-level instructions to an NMR probe.

Further advantages can be extracted from the description and the enclosed drawing. The features mentioned above and below can be used in accordance with the invention either individually or collectively in any combination. The embodiments mentioned are not to be understood as exhaustive enumeration but rather have exemplary character for the description of the invention.

### Detailed description of the invention and drawing

The invention is shown in the drawing and is explained in more detail on the basis of illustrative embodiments.

The invention is shown in the drawings:
- Fig. 1: schematically shows an NMR probe head according to the invention with a mechanical apparatus having a carrier stage and an actuator platform, a control system and a spectrometer console;
- Fig. 2a: shows in a schematic stereoscopic view an embodiment of the mechanical apparatus with the carrier stage adapted for movement in Cartesian XYZ-coordinates;
- Fig. 2b: shows the embodiment of Fig. 2a in a side view looking in a y-direction;
- Fig. 2c: shows the embodiment of Fig. 2a without the upper cap of the mechanical apparatus thus displaying more details of the carrier stage;
- Fig. 3a: shows in a schematic stereoscopic view an embodiment of the mechanical apparatus with the carrier stage adapted for movement in cylindrical pφZ-coordinates;
- Fig. 3b: shows the embodiment of Fig. 3a in a side view looking in a y-direction;
- Fig. 3c: shows the embodiment of Fig. 3a without the upper cap of the mechanical apparatus thus displaying more details of the carrier stage;
- Fig. 4a: shows -in a schematic partial stereoscopic view- an embodiment of the engagement system with a latching/unlatching mechanism in a released state;
- Fig. 4b: shows the embodiment of Fig. 4a in a locked state;
- Fig. 4c: shows -in a schematic partially transparent side view- the embodiment of Fig. 4a in a released state; and
- Fig.4d: shows the embodiment of Fig. 4c in a locked state;

The present invention is presenting a novel **NMR probe head 10** for use in an NMR spectrometer. The probe head 10 contains a **mechanical apparatus 11; 11'; 11"** designed and adapted for remotely tuning, matching and controlling an NMR probe head 10 during operation of the NMR spectrometer. The mechanical apparatus 11; 11'; 11" comprises a plurality of **adjustment rods 12** to mechanically adjust mechanical or electric parts in the NMR probe head 10 requiring manipulation, the adjustment rods 12 essentially arranged in a Z-direction and being mechanically coupled to an **actuator 13'; 13"** via an **engagement system 14.** Further, the NMR spectrometer is containing a **control system 15** to control the movement of the actuator 13'; 13".

The NMR probe head 10 according to the invention is characterized in that the mechanical apparatus 11; 11'; 11" comprises an **actuator platform 16'; 16"** to which a single main actuator 13'; 13" is attached, the platform 16'; 16" being movably connected to a **carrier stage 17'; 17".** The carrier stage 17'; 17" is equipped with three **actuating elements 13'a,13'b,13'c; 13"a,13"b,13"c** arranged thereon and enabling the carrier stage 17'; 17" to move the actuator platform 16'; 16" into any required spatial position relative to the adjustment rods 12. The engagement system 14 comprises **receiving elements 14b** arranged on the lower ends of each of the adjustment rods 12 and an **inserting element 14a** arranged on the top end of the main actuator 13'; 13", wherein the inserting element 14a is designed and adapted for fitting in anyone of the receiving elements 14b to mechanically couple the corresponding adjustment rod 12 with the main actuator 13'; 13" to provide a transmission of rotational and/or translational movement from the main actuator 13'; 13" to the adjustment rod 12.

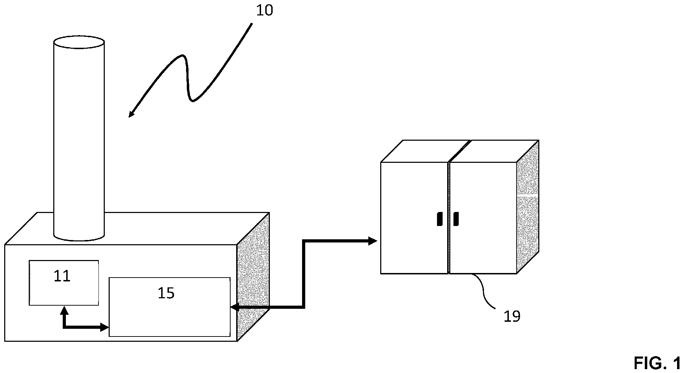

**Fig. 1** in a very schematic form depicts the main constituents of the NMR probe head 10 according to the invention with the mechanical apparatus 11 and the control system 15 comprising hardware and software components, both physically implemented in a probe base. A **spectrometer console 19** of the the NMR spectrometer is electrically connected to the control system 15 and controllable by a user of the NMR spectrometer by providing the input of high-level instructions to an NMR probe.

The NMR spectrometer user interacts with the probe via the spectrometer console 19. High-level commands are sent by the spectrometer console 19 to the actuator controller 15 which in turn sends the required instructions to the actuators in the actuator platform 16'; 16", to realize the task demanded by the spectrometer console 19. The actuator 13'; 13" as well as the actuating elements 13'a,13'b,13'c; 13"a,13"b,13"c may provide feedback to the controller 15, which will determine if the task was completed successfully or not, and that information will be relayed back to the spectrometer console 19 by the actuator controller 15.

The control system 15 comprises a hardware portion -not shown in the figures-to generate motion and a software interface to control the motion of the three actuating elements 13'a,13'b,13'c; 13"a,13"b,13"c of the carrier stage 17'; 17" for moving the actuator platform 16'; 16" into a spatial position appropriate for coupling the main actuator 13'; 13" to a selected adjustment rod 12, for coupling the actuator 13'; 13" to this selected adjustment rod 12, and for operating the actuator 13'; 13" according to the requirements of moving this selected adjustment rod 12 in order to mechanically adjust the mechanical or electric part of an NMR probe connected to this selected adjustment rod 12.

In particular, the main actuator 13'; 13" is designed for the remote-controlled adjustment of electrical and/or mechanical units, for example capacitive trimmers, variable resistors, adjustable inductances for the frequency setting or the tilting of the MAS stator in an NMR probe head of the NMR spectrometer with several drive units and several gear units which are coupled to a plurality of adjustment rods of the probe.

The main actuator 13'; 13" mounted to the actuator platform 16'; 16" and/or one or more of the three actuating elements 13'a,13'b,13'c; 13"a,13"b,13"c of the carrier stage 17'; 17" may comprise a DC motor, a piezoelectric element or a pneumatic operator - not being shown in the drawings.

The software interface of the control system 15 is designed and adapted for automatically initiating and controlling the motion of the three actuating elements 13'a,13'b,13'c; 13"a,13"b,13"c of the carrier stage 17'; 17" and of the main actuator 13'; 13" mounted to the actuator platform 16'; 16" upon input of high-level instructions to the NMR probe in a spectrometer console 19 by a user of the NMR spectrometer.

Further, the software interface of the control system 15 is designed and adapted to facilitate automatic tuning, matching, activation of mechanical switches in NMR probes, and preferably additionally in MAS-NMR probes, the adjustment of orientation of an MAS stator.

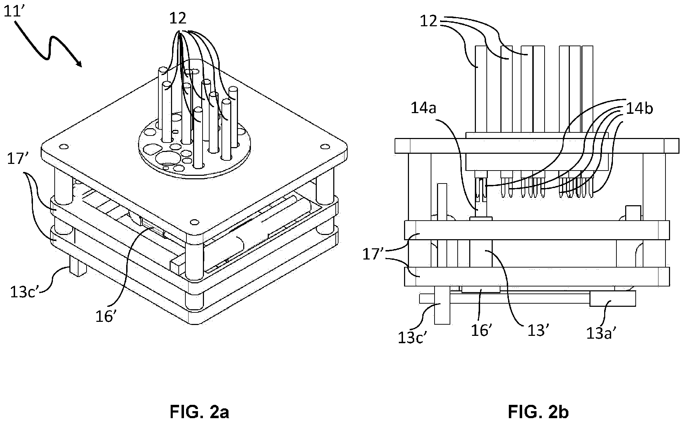

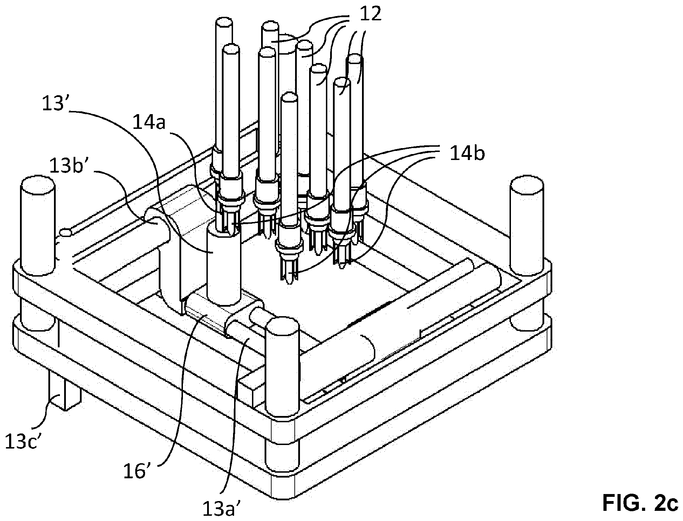

The **Figures 2a to 2c** illustrate an embodiment of the mechanical apparatus 11' with the carrier stage 17' being designed and adapted for movement in Cartesian XYZ-coordinates comprising a first actuating element 13'a for linear motion in an X-direction, a second actuating element 13'b for linear motion in a Y-direction perpendicular to the X-direction, and a third actuating element 13'c for linear motion in the Z-direction perpendicular to the X-direction and the Y-direction and parallel to the direction of the axes of the adjustment rods 12. The actuator platform 16' in this embodiment is based only on translational motion. Thus, the main actuator 13' is here positioned based on Cartesian coordinates.

A selected one out of the plurality of adjustment rods 12 is mechanically coupled to the inserting element 14a of the main actuator 13' via its receiving element 14b as shown in these figures.

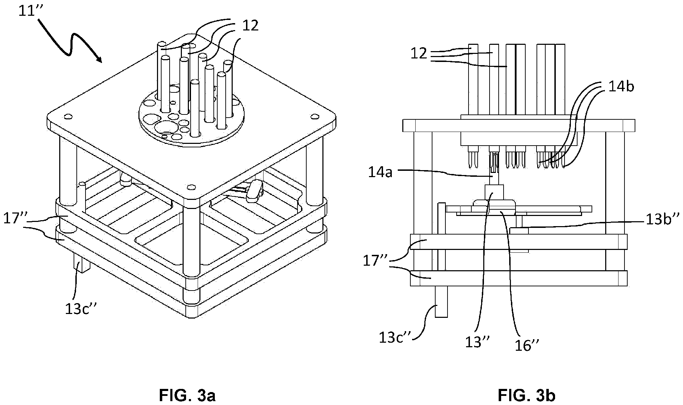

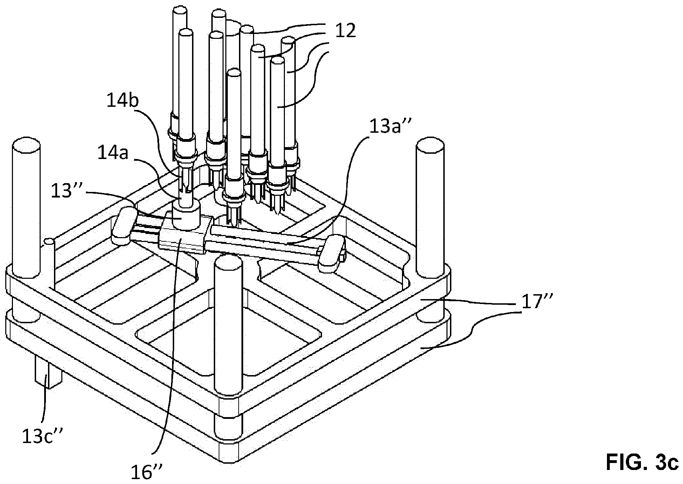

The **Figures 3a to 3c** illustrate an embodiment of the mechanical apparatus 11" with the carrier stage 17" being designed and adapted for moving the actuator platform 16" in cylindrical pφZ-coordinates, comprising a first actuating element 13"a for linear motion in a radial p-direction, a second actuating element 13"b for rotary motion in a φ-direction, and a third actuating element 13"c for linear motion in the Z-direction parallel to the direction of the axes of the adjustment rods 12. The actuator platform 16" in this embodiment is based on rotational and translational motion. Thus, the main actuator 13' is here positioned based on cylindrical coordinates.

In embodiments of the invention, the mechanical apparatus 11; 11'; 11" can also be designed and adapted for enabling a combined translational and rotational movement of the actuator 13'; 13", whereby the actuator 13'; 13" is performing a rotational motion and the third actuating element 13'c; 13"c is performing a linear motion in Z-direction which is transmitted to the actuator 13'; 13" via the actuator platform 16'; 16".

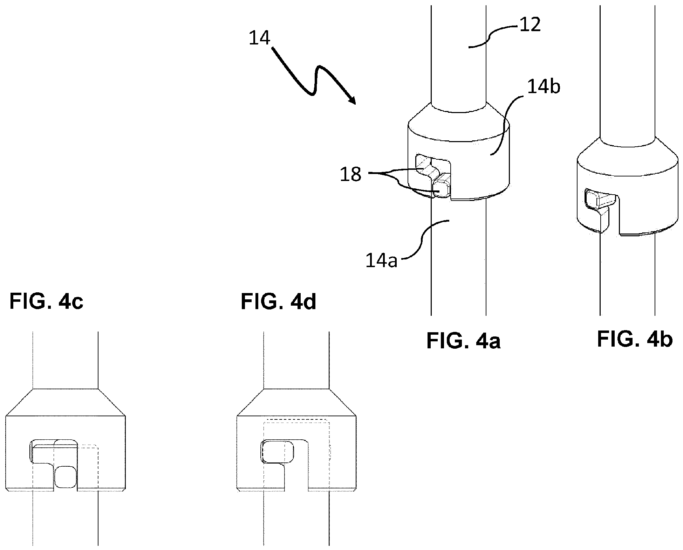

The **Figures 4a to 4d** illustrate an embodiment of the engagement system 14 being provided with a **latching/unlatching mechanism 18** enabling the inserting element 14a of the actuator 13'; 13" to be locked in the receiving element 14b of an adjustment rod 12 in a releasable manner. Whereas the Figures 4a and 4c show the mechanism 18 in a released state, the Figures 4b and 4d depict it in a locked state.

The latching/unlatching mechanism 18 can be locked and released mechanically and/or electro-magnetically.

### List of reference signs:

- 10: NMR probe head
- 11; 11'; 11": mechanical apparatus
- 12: plurality of adjustment rods
- 13'; 13": main actuator
- 13'a,13'b,13'c; 13"a, 13"b, 13"c: actuating elements
- 14: engagement system
- 14a: inserting element
- 14b: receiving elements
- 15: control system
- 16'; 16": actuator platform
- 17'; 17": carrier stage
- 18: latching/unlatching mechanism
- 19: spectrometer console

### List of prior art citations:

Publications considered for assessing patentability of the present invention:
[1] DE 197 44 763 C2 ≈ EP 0 908 738 B1 ≈ US 6,204,665 B1 ≈ JP 3164555 B2
[2] EP 0 518 100 B1 ≈ US 5,274,330 A
[3] US 6,323,647 B1
[4] WO 2019/100173 A1
[5] US 7,800,369 B2

## Claims

1. **NMR** probe head (10) for use in an NMR spectrometer, the probe head (10) containing a mechanical apparatus (11; 11'; 11") designed and adapted for remotely tuning, matching and controlling an NMR probe head (10) during operation of the NMR spectrometer, the mechanical apparatus (11; 11'; 11") comprising a plurality of adjustment rods (12) to mechanically adjust mechanical or electric parts in the NMR probe head (10) requiring manipulation, the adjustment rods (12) essentially arranged in a Z-direction and being mechanically coupled to an actuator (13'; 13") via an engagement system (14), and containing a control system (15) to control the movement of the actuator (13'; 13"),
**characterized in**
**that** the mechanical apparatus (11; 11'; 11") comprises an actuator platform (16'; 16") to which the actuator (13'; 13") is attached, the platform (16'; 16") being movably connected to a carrier stage (17'; 17");
**that** the carrier stage (17'; 17") is equipped with three actuating elements (13'a, 13'b, 13'c; 13"a,13"b,13"c) arranged thereon and enabling the carrier stage (17'; 17") to move the actuator platform (16'; 16") into any required spatial position relative to the adjustment rods (12);
and **that** the engagement system (14) comprises receiving elements (14b) arranged on the lower ends of each of the adjustment rods (12) and an inserting element (14a) arranged on the top end of the actuator (13'; 13"), wherein the inserting element (14a) is designed and adapted for fitting in anyone of the receiving elements (14b) to mechanically couple the corresponding adjustment rod (12) with the actuator (13'; 13") to provide a transmission of rotational and/or translational movement from the actuator (13'; 13") to the adjustment rod (12).

2. **NMR** probe head according to claim 1, **characterized in that** the carrier stage (17') is designed and adapted for moving the actuator platform (16') in Cartesian XYZ-coordinates, comprising a first actuating element (13'a) for linear motion in an X-direction, a second actuating element (13'b) for linear motion in a Y-direction perpendicular to the X-direction, and a third actuating element (13'c) for linear motion in the Z-direction perpendicular to the X-direction and the Y-direction and parallel to the direction of the axes of the adjustment rods (12).

3. NMR probe head according to claim 1, **characterized in that** the carrier stage (17") is designed and adapted for moving the actuator platform (16") in cylindrical pφZ-coordinates, comprising a first actuating element (13"a) for linear motion in a radial p-direction, a second actuating element (13"b) for rotary motion in a φ-direction, and a third actuating element (13"c) for linear motion in the Z-direction parallel to the direction of the axes of the adjustment rods (12).

4. NMR probe head according to claim 2 or 3, **characterized in that** the mechanical apparatus (11; 11'; 11") is designed and adapted for enabling a combined translational and rotational movement of the actuator (13'; 13"), whereby the actuator (13'; 13") is performing a rotational motion and the third actuating element (13'c; 13"c) is performing a linear motion in Z-direction which is transmitted to the actuator (13'; 13") via the actuator platform (16'; 16").

5. NMR probe head according to anyone of the preceding claims, **characterized in that** the engagement system (14) is provided with a latching/unlatching mechanism (18) enabling the inserting element (14a) of the actuator (13'; 13") to be locked in the receiving element (14b) of an adjustment rod (12) in a releasable manner.

6. NMR probe head according to claim 5, **characterized in that** the latching/unlatching mechanism (18) can be locked and released mechanically and/or electro-magnetically.

7. NMR probe head according to anyone of the preceding claims, **characterized in that** the control system (15) comprises a hardware portion to generate motion and a software interface to control the motion of the three actuating elements (13'a, 13'b, 13'c; 13"a, 13"b, 13"c) of the carrier stage (17'; 17") for moving the actuator platform (16'; 16") into a spatial position appropriate for coupling the actuator (13'; 13") to a selected adjustment rod (12), for coupling the actuator (13'; 13") to this selected adjustment rod (12), and for operating the actuator (13'; 13") according to the requirements of moving this selected adjustment rod (12) in order to mechanically adjust the mechanical or electric part of an NMR probe connected to this selected adjustment rod (12).

8. NMR probe head according to claim 7, **characterized in that** the software interface of the control system (15) is designed and adapted for automatically initiating and controlling the motion of the three actuating elements (13'a, 13'b, 13'c; 13"a,13"b,13"c) of the carrier stage (17'; 17") and of the actuator (13'; 13") mounted to the actuator platform (16'; 16") upon input of high-level instructions to the NMR probe in a spectrometer console (19) by a user of the NMR spectrometer.

9. NMR probe head according to claim 8, **characterized in that** the software interface of the control system (15) is designed and adapted to facilitate automatic tuning, matching, activation of mechanical switches in NMR probes, and preferably additionally in MAS-NMR probes, the adjustment of orientation of an MAS stator.

10. NMR probe head according to anyone of the preceding claims, **characterized in that** the adjustment rods (12) are designed and adapted to mechanically adjust trimmer capacitors, variable resistors, switches, or inductors and/or MAS angle adjustment elements.

11. NMR probe head according to anyone of the preceding claims, **characterized in that** the actuator (13'; 13") mounted to the actuator platform (16'; 16") and/or one or more of the three actuating elements (13'a,13'b,13'c; 13"a, 13"b, 13"c) of the carrier stage (17'; 17") comprise a DC motor, a piezoelectric element or a pneumatic operator.

12. NMR spectrometer with an NMR probe head (10) according to anyone of the preceding claims, **characterized in that** the NMR spectrometer comprises a spectrometer console (19) controllable by a user of the NMR spectrometer by providing the input of high-level instructions to an NMR probe.

## Patentansprüche

1. NMR-Probenkopf (10) zur Verwendung in einem NMR-Spektrometer, wobei der Probenkopf (10) eine mechanische Vorrichtung (11; 11'; 11") enthält, die zum ferngesteuerten Abstimmen, Anpassen und Steuern eines NMR-Probenkopfs (10) während des Betriebs des NMR-Spektrometers ausgelegt und angepasst ist, wobei die mechanische Vorrichtung (11; 11'; 11") eine Vielzahl von Einstellstangen (12) zum mechanischen Einstellen von mechanischen oder elektrischen Teilen in dem NMR-Probenkopf (10) umfasst, die eine Manipulation erfordern, wobei die Einstellstangen (12) im Wesentlichen in einer Z-Richtung angeordnet und an ein Betätigungsglied (13'; 13") über ein Eingriffssystem (14) mechanisch gekoppelt sind und ein Steuersystem (15) enthalten, um die Bewegung des Betätigungsglieds (13'; 13") zu steuern,
**dadurch gekennzeichnet,**
**dass** die mechanische Vorrichtung (11; 11'; 11") eine Plattform (16'; 16") für ein Betätigungsglied umfasst, an der das Betätigungsglied (13'; 13") befestigt ist, wobei die Plattform (16'; 16") mit einer Trägerstufe (17'; 17") bewegbar verbunden ist;
**dass** die Trägerstufe (17'; 17") mit drei darauf angeordneten Betätigungselementen (13'a,13'b,13'c; 13"a, 13"b, 13"c) ausgestattet ist, und
wobei die Trägerstufe (17'; 17") aktiviert wird, um die Betätigungsgliedplattform (16'; 16") in eine beliebige erforderliche räumliche Position relativ zu den Einstellstangen (12) zu bewegen;
und **dass** das Eingriffssystem (14) Aufnahmeelemente (14b) umfasst, die an den unteren Enden jeder der Einstellstangen (12) angeordnet sind, sowie ein Einführelement (14a), das an dem oberen Ende des Betätigungselements (13'; 13") angeordnet ist, wobei das Einführelement (14a) ausgelegt und angepasst ist, um in eines der Aufnahmeelemente (14b) zu passen, um die entsprechende Einstellstange (12) mit dem Betätigungsglied (13'; 13") mechanisch zu koppeln, um eine Übertragung von Rotations- und/oder Translationsbewegung von dem Betätigungsglied (13'; 13") an die Einstellstange (12) bereitzustellen.

2. NMR-Probenkopf nach Anspruch 1, **dadurch gekennzeichnet, dass** die Trägerstufe (17') zum Bewegen der Plattform (16') für ein Betätigungsglied in kartesischen XYZ-Koordinaten ausgelegt und angepasst ist, umfassend ein erstes Betätigungselement (13'a) für lineare Bewegung in einer X-Richtung, ein zweites Betätigungselement (13'b) für lineare Bewegung in einer Y-Richtung senkrecht zu der X-Richtung, und ein drittes Betätigungselement (13'c) für lineare Bewegung in der Z-Richtung senkrecht zu der X-Richtung und der Y-Richtung und parallel zu der Richtung der Achsen der Einstellstangen (12).

3. NMR-Probenkopf nach Anspruch 1, **dadurch gekennzeichnet, dass** die Trägerstufe (17") zum Bewegen der Plattform (16") für ein Betätigungsglied in zylindrischen pφZ-Koordinaten ausgelegt und angepasst ist, umfassend ein erstes Betätigungselement (13"a) für lineare Bewegung in einer radialen p-Richtung, ein zweites Betätigungselement (13"b) für Rotationsbewegung in einer φ-Richtung, und ein drittes Betätigungselement (13"c) für lineare Bewegung in der Z-Richtung parallel zu der Richtung der Achsen der Einstellstangen (12).

4. NMR-Probenkopf nach Anspruch 2 oder 3, **dadurch gekennzeichnet, dass** die mechanische Vorrichtung (11; 11'; 11") zum Aktivieren einer kombinierten translatorischen und rotatorischen Bewegung des Betätigungsglieds (13'; 13") ausgelegt und angepasst ist, wobei das Betätigungsglied (13'; 13") eine Rotationsbewegung durchführt und das dritte Betätigungselement (13'c; 13"c) eine lineare Bewegung in Z-Richtung durchführt, die über die Plattform (16'; 16") für ein Betätigungsglied auf das Betätigungsglied (13'; 13") übertragen wird.

5. NMR-Probenkopf nach einem der vorhergehenden Ansprüche, **dadurch gekennzeichnet, dass** das Eingriffssystem (14) mit einem Verriegelungs-/Entriegelungsmechanismus (18) versehen ist, der das Einführelement (14a) des Betätigungsglieds (13'; 13") aktiviert, in dem Aufnahmeelement (14b) einer Einstellstange (12) lösbar verschlossen zu werden.

6. NMR-Probenkopf nach Anspruch 5, **dadurch gekennzeichnet, dass** der Verriegelungs- / Entriegelungsmechanismus (18) mechanisch und/oder elektromagnetisch verschlossen und gelöst werden kann.

7. NMR-Probenkopf nach einem der vorhergehenden Ansprüche, **dadurch gekennzeichnet, dass** das Steuersystem (15) einen Hardwareabschnitt umfasst, um Bewegung zu erzeugen, sowie eine Softwareschnittstelle, um die Bewegung der drei Betätigungselemente (13'a, 13'b, 13'c; 13"a, 13"b, 13"c) der Trägerstufe (17'; 17") zu steuern, um die Plattform (16'; 16") für ein Betätigungsglied in eine räumliche Position zu bewegen, die zum Koppeln des Betätigungsglieds (13'; 13") mit einer ausgewählten Einstellstange (12), zum Koppeln des Betätigungsglieds (13'; 13") mit dieser ausgewählten Einstellstange (12) und zum Betreiben des Betätigungsglieds (13'; 13") gemäß den Anforderungen des Bewegens dieser ausgewählten Einstellstange (12) geeignet ist, um den mechanischen oder elektrischen Teil einer NMR-Sonde, die mit dieser ausgewählten Einstellstange (12) verbunden ist, mechanisch einzustellen.

8. NMR-Probenkopf nach Anspruch 7, **dadurch gekennzeichnet, dass** die Softwareschnittstelle des Steuersystems (15) bei Eingabe von High-Level-Anweisungen an die NMR-Sonde in einer Spektrometer Konsole (19) durch einen Benutzer des NMR-Spektrometers zum automatischen Initiieren und Steuern der Bewegung der drei Betätigungselemente (13'a, 13'b, 13'c; 13"a, 13"b, 13"c) der Trägerstufe (17'; 17") und des Betätigungsglieds (13'; 13"), das an der Plattform (16'; 16") für ein Betätigungsglied montiert ist, ausgelegt und angepasst ist.

9. NMR-Probenkopf nach Anspruch 8, **dadurch gekennzeichnet, dass** die Softwareschnittstelle des Steuersystems (15) ausgelegt und angepasst ist, um automatisches Abstimmen, Anpassen, Aktivieren von mechanischen Schaltern in NMR-Sonden und vorzugsweise zusätzlich in MAS-NMR-Sonden, die Einstellung der Orientierung eines MAS-Stators zu ermöglichen.

10. NMR-Probenkopf nach einem der vorhergehenden Ansprüche, **dadurch gekennzeichnet, dass** die Einstellstangen (12) ausgelegt und angepasst sind, um Trimmerkondensatoren, variable Widerstände, Schalter oder Induktivitäten und/oder MAS-Winkel-Einstellelemente mechanisch einzustellen.

11. NMR-Probenkopf nach einem der vorhergehenden Ansprüche, **dadurch gekennzeichnet, dass** das Betätigungsglied (13'; 13"), das an der Plattform (16'; 16") für ein Betätigungsglied montiert ist, und/oder eines oder mehrere der drei Betätigungselemente (13'a, 13'b, 13'c; 13"a, 13"b, 13"c) der Trägerstufe (17'; 17") einen Gleichstrommotor, ein piezoelektrisches Element oder einen pneumatischen Antrieb umfassen.

12. NMR-Spektrometer mit einem NMR-Probenkopf (10) nach einem der vorhergehenden Ansprüche, **dadurch gekennzeichnet, dass** das **NMR-**Spektrometer eine Spektrometer Konsole (19) umfasst, die durch einen Benutzer des NMR-Spektrometers durch das Bereitstellen der Eingabe von High-Level-Anweisungen an eine NMR-Sonde steuerbar ist.

## Revendications

1. Tête de sonde RMN (10) destinée à être utilisée dans un spectromètre RMN, la tête de sonde (10) contenant un dispositif mécanique (11 ; 11' ; 11") conçu et adapté pour le réglage à distance, l'adaptation d'impédance et la commande d'une tête de sonde RMN (10) pendant le fonctionnement du spectromètre RMN, le dispositif mécanique (11 ; 11' ; 11") comprenant une pluralité de tiges de réglage (12) pour ajuster mécaniquement des éléments mécaniques ou électriques dans la tête de sonde RMN (10) nécessitant une manipulation, les tiges de réglage (12) étant essentiellement disposées dans une direction Z et étant couplées mécaniquement à un actionneur (13' ; 13") via un système d'accouplement (14), et contenant un système de commande (15) pour commander le mouvement de l'actionneur (13' ; 13"),
**caractérisée en ce que**
le **dispositif mécanique (11** ; 11' ; 11") comprend une plateforme d'actionneur (16' ; 16") à laquelle l'actionneur (13' ; 13") est fixé, la plateforme (16' ; 16") étant reliée de manière mobile à un plateau support (17' ; 17") ; **en ce que** le plateau support (17' ; 17") est équipé de trois éléments d'actionnement (13'a, 13'b, 13'c ; 13"a, 13"b, 13"c) qui sont disposés dessus et permettant au plateau support (17' ; 17") de déplacer la plateforme d'actionneur (16' ; 16") dans toute position spatiale requise par rapport aux tiges de réglage (12);
**en ce que** le plateau support (17' ; 17") est équipé de trois éléments d'actionnement (13'a, 13'b, 13'c ; 13"a, 13"b, 13"c) qui sont disposés dessus et permettant au plateau support (17' ; 17") de déplacer la plateforme d'actionneur (16' ; 16") dans toute position spatiale requise par rapport aux tiges de réglage (12);
et **en ce que** le système d'accouplement (14) comprend des éléments de réception (14b) disposés sur les extrémités inférieures de chacune des tiges de réglage (12) et un élément d'insertion (14a) disposé sur l'extrémité supérieure de l'actionneur (13' ; 13"), lequel élément d'insertion (14a) est conçu et adapté pour s'insérer dans l'un quelconque des éléments de réception (14b) afin de coupler mécaniquement la tige de réglage (12) correspondante à l'actionneur (13' ; 13") pour assurer une transmission du mouvement de rotation et/ou du mouvement de translation de l'actionneur (13' ; 13") à la tige de réglage (12).

2. Tête de sonde RMN selon la revendication 1, **caractérisée en ce que** le plateau support (17') est conçu et adapté pour déplacer la plateforme d'actionneur (16') selon des coordonnées cartésiennes XYZ, comprenant un premier élément d'actionnement (13'a) pour un mouvement linéaire dans une direction X, un deuxième élément d'actionnement (13'b) pour un mouvement linéaire dans une direction Y perpendiculaire à la direction X, et un troisième élément d'actionnement (13'c) pour un mouvement linéaire dans la direction Z perpendiculaire à la direction X et à la direction Y et parallèle à la direction des axes des tiges de réglage (12).

3. Tête de sonde RMN selon la revendication 1, **caractérisée en ce que** le plateau support (17") est conçu et adapté pour déplacer la plateforme d'actionneur (16") selon des coordonnées cylindriques pφZ, comprenant un premier élément d'actionnement (13"a) pour un mouvement linéaire dans une direction radiale p, un deuxième élément d'actionnement (13"b) pour un mouvement rotatif dans une direction φ, et un troisième élément d'actionnement (13"c) pour un mouvement linéaire dans la direction Z parallèle à la direction des axes des tiges de réglage (12).

4. Tête de sonde RMN selon la revendication 2 ou 3, **caractérisée en ce que** le dispositif mécanique (11 ; 11' ; 11") est conçu et adapté pour permettre un mouvement combiné de translation et de rotation de l'actionneur (13' ; 13"), dans lequel l'actionneur (13' ; 13") effectue un mouvement de rotation et le troisième élément d'actionnement (13'c ; 13"c) effectue un mouvement linéaire dans la direction Z qui est transmis à l'actionneur (13' ; 13") via la plateforme d'actionneur (16' ; 16").

5. Tête de sonde RMN selon l'une quelconque des revendications précédentes, **caractérisée en ce que** le système d'accouplement (14) est pourvu d'un mécanisme de verrouillage/déverrouillage (18) permettant à l'élément d'insertion (14a) de l'actionneur (13' ; 13") d'être verrouillé dans l'élément de réception (14b) d'une tige de réglage (12) de manière libérable.

6. Tête de sonde RMN selon la revendication 5, **caractérisée en ce que** le mécanisme de verrouillage/déverrouillage (18) peut être verrouillé et libéré mécaniquement et/ou électromagnétiquement.

7. Tête de sonde RMN selon l'une quelconque des revendications précédentes, **caractérisée en ce que** le système de commande (15) comprend une partie matérielle pour générer le mouvement et une interface logicielle pour commander le mouvement des trois éléments d'actionnement (13'a, 13'b, 13'c ; 13"a, 13"b, 13"c) du plateau support (17' ; 17") afin de déplacer la plateforme d'actionneur (16' ; 16") dans une position spatiale appropriée pour coupler l'actionneur (13' ; 13") à une tige de réglage (12) sélectionnée, pour coupler l'actionneur (13' ; 13") à cette tige de réglage (12) sélectionnée, et pour faire fonctionner l'actionneur (13' ; 13") selon les exigences de déplacement de cette tige de réglage (12) sélectionnée afin d'ajuster mécaniquement l'élément mécanique ou électrique d'une sonde RMN connectée à cette tige de réglage (12) sélectionnée.

8. Tête de sonde RMN selon la revendication 7, **caractérisée en ce que** l'interface logicielle du système de commande (15) est conçue et adaptée pour initier et commander automatiquement le mouvement des trois éléments d'actionnement (13'a, 13'b, 13'c ; 13"a, 13"b, 13"c) du plateau support (17' ; 17") et de l'actionneur (13' ; 13") monté sur la plateforme d'actionneur (16' ; 16") lors de la saisie d'instructions de haut niveau à la sonde RMN dans une console de spectromètre (19) par un utilisateur du spectromètre RMN.

9. Tête de sonde RMN selon la revendication 8, **caractérisée en ce que** l'interface logicielle du système de commande (15) est conçue et adaptée pour faciliter le réglage automatique, l'adaptation d'impédance, l'activation des commutateurs mécaniques dans les sondes RMN, et de préférence également dans les sondes RMN-MAS, l'ajustement de l'orientation d'un stator MAS.

10. Tête de sonde RMN selon l'une quelconque des revendications précédentes, **caractérisée en ce que** les tiges de réglage (12) sont conçues et adaptées pour ajuster mécaniquement des condensateurs de réglage, des résistances variables, des commutateurs ou des inductances et/ou des éléments de réglage d'angle MAS.

11. Tête de sonde RMN selon l'une quelconque des revendications précédentes, **caractérisée en ce que** l'actionneur (13' ; 13") monté sur la plateforme d'actionneur (16' ; 16") et/ou un ou plusieurs des trois éléments d'actionnement (13'a,13'b,13'c ; 13"a,13"b,13"c) du plateau support (17' ; 17") comprennent un moteur à courant continu, un élément piézoélectrique ou un opérateur pneumatique.

12. Spectromètre RMN avec une tête de sonde RMN (10) selon l'une quelconque des revendications précédentes, **caractérisé en ce que** le spectromètre RMN comprend une console de spectromètre (19) commandable par un utilisateur du spectromètre RMN en fournissant la saisie d'instructions de haut niveau à une sonde RMN.
